# EUROPÄISCHE PATENTANMELDUNG

(11) **EP 2 157 845 A1**
(43) Veröffentlichungstag der Anmeldung: **24.02.2010**
(21) Anmeldenummer: 08014456.1
(22) Anmeldetag: 13.08.2008
(51) Int. Cl.: H05K 7/14

(54) **Automatisierungsgerät**

(71) Anmelder: Siemens Aktiengesellschaft, 80333 München (DE)
(72) Erfinder: Bleiweiss, Heinz, 76437 Rastatt (DE)

(57) **Zusammenfassung**

Die Erfindung betrifft ein Automatisierungsgerät, welches mehrere auf einer Tragschiene (1) angeordnete Baugruppen (2, 3; 16, 17; 21, 22) aufweist, mit einem an der Rückwand jeder Baugruppe (2, 3; 16, 17; 21, 22) angeordneten, mehrere Kontakte aufweisenden Baugruppen-Modulteil, welches mit einer in der Baugruppe (2, 3; 16, 17; 21, 22) angeordneten Leiterplatte verbunden ist und welches mit einem mehrere Kontakte aufweisenden Verbindungs-Modulteil (4-6; 10-12; 18-20) elektrisch und mechanisch zusammenwirkt. Es werden Maßnahmen vorgeschlagen, mit welchen eine im Wesentlichen optimale Belegung der Tragschiene mit Baugruppen des Automatisierungsgerätes ermöglicht wird.

## Beschreibung

Die Erfindung betrifft ein Automatisierungsgerät, welches mehrere auf einer Tragschiene angeordnete Baugruppen aufweist, wobei an der Rückwand jeder Baugruppe ein mehrere Kontakte aufweisendes Baugruppen-Modulteil vorgesehen ist, das mit einem ebenfalls mehrere Kontakte aufweisenden Verbindungs-Modulteil elektrisch und mechanisch zusammenwirkt.

Ein Automatisierungsgerät der eingangs genannten Art ist aus der DE 42 25 573 C2 bekannt. Jede Baugruppe dieses Automatisierungsgerätes weist ein im Wesentlichen U-förmiges Baugruppen-Busmodulteil auf, welches zur Herstellung einer Busverbindung mit einer benachbarten Baugruppe mit einem ebenfalls im Wesentlichen U-förmigen Verbindungs-Busmodulteil elektrisch und mechanisch verbunden ist. Die Basis und die Schenkel eines Verbindungs-Busmodulteils überbrücken dabei den Abstand zwischen einem Schenkel eines Baugruppen-Busmodulteils von einem benachbarten Schenkel einer benachbarten Baugruppe. Der Zusammenbau des Automatisierungsgerätes erfolgt vorzugsweise in der Art und Weise, dass jeweils in den rechten Schenkel der Baugruppen ein Schenkel des Verbindungs-Busmodulteils eingesetzt wird, so dass der rechte Schenkel des jeweiligen Verbindungs-Busmodulteils rechts hinten aus den Baugruppen hervorragt. Anschließend werden die Baugruppen nach- und nebeneinander auf eine Tragschiene aufgeschwenkt, wobei durch das Aufschwenken zwangsweise die elektrische Verbindung benachbarter Baugruppen hergestellt wird. Die Schenkel der im Wesentlichen U-förmigen Baugruppen-Busmodulteile der Baugruppen weisen stets den gleichen Abstand von der nächstliegenden Seitenwand der jeweiligen Baugruppe auf, wodurch Baugruppen unterschiedlicher Breite auf die Verbindungs-Busmodulteile gesteckt werden können.

Aus der EP 0 236 711 B1 ist ein Automatisierungsgerät mit einem Rückwandbus bekannt, welcher aus mehreren auf eine Tragschiene montierbaren Baugruppenträgern verwirklicht ist. Die Busverbindung wird dadurch bewirkt, dass benachbarte Baugruppenträger über ein Flachbandkabel miteinander verbunden sind, wobei auf die Baugruppenträger Baugruppen gleicher Breite aufgeschwenkt werden können.

Der vorliegenden Erfindung liegt die Aufgabe zugrunde, ein Automatisierungsgerät der eingangs genannten Art zu schaffen, welches eine im Wesentlichen optimale Belegung der Tragschiene mit Baugruppen des Automatisierungsgerätes ermöglicht.

Diese Aufgabe wird durch die im kennzeichnenden Teil des Anspruchs 1 angegebenen Maßnahmen gelöst.

Vorteilhaft ist, dass Baugruppen beliebiger Breite eingesetzt werden können, wobei "Steckplatz- bzw. Einbauverluste" vermieden werden. Die gesamte Breite einer beliebig breiten Tragschiene kann genutzt werden, um Baugruppen auf dieser anzuordnen. Dabei können unterschiedliche physikalische Topologien eines Rückwandbusses eines Automatisierungsgerätes verwirklicht werden. Es können beispielsweise Verbindungsstrukturen in Form einer Stern- und/oder Busverbindung verwirklicht werden, wobei eine Mischung der verschiedenen Strukturen möglich ist. Es wird ein "rasterfreier" modularer Systemaufbau geschaffen, wobei eine Miniaturisierung (Baubreitenreduktion) in Ratio-Phasen über eine Produktfamilien-Lebensdauer möglich ist. Eine im Wesentlichen vollständige Steckplatznutzung wird gewährleistet, da "Steckplatzverluste" vermieden werden.
Durch den Einsatz verschiebbarer Einbausteckplätze kann eine ("mitwachsende") Punkt-zu-Punkt-Kopplung, eine Buskopplung, eine HUB- oder eine Switch-Struktur verwirklicht werden. Dabei ist nur eine Baugruppenfamilie für unterschiedliche, abgestufte Performance-Klassen erforderlich.

In einer Ausgestaltung der Erfindung gemäß den im Anspruch 2 angegebenen Maßnahmen wird ferner ermöglicht, eine so genannte Daisy-Chain-Verbindungsstruktur zu verwirklichen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figuren 1 bis 3: Prinzipdarstellungen von Einbauplätzen für Baugruppen eines Automatisierungsgerätes und
- Figur 4: eine Schnittdarstellung von Einbauplätzen.

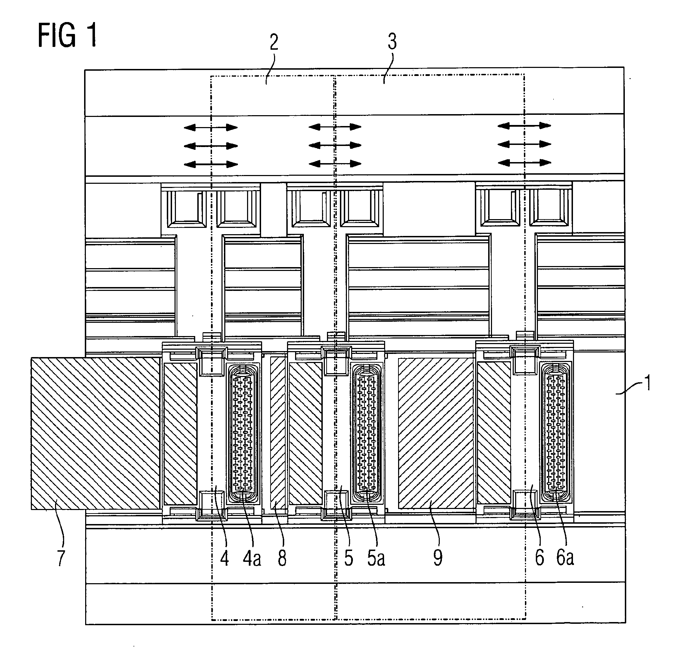

Die in den Figuren 1 bis 4 dargestellten gleichen Teile sind mit gleichen Bezugszeichen versehen.

In Figur 1 ist mit 1 eine Tragschiene bezeichnet, auf welcher Baugruppen 2, 3 eines Automatisierungsgerätes angeordnet und montiert sind. Das Automatisierungsgerät weist gewöhnlich mindestens eine Zentral- bzw. CPU-Baugruppe und mehrere Digitalein/-ausgabe-, Analogein/-ausgabe-, Kommunikations- und/oder weitere Funktions-Baugruppen zur Steuerung eines technischen Prozesses auf. Die Baugruppen 2, 3 sind jeweils mit einem hier nicht dargestellten, mit einer Leiterplatte elektrisch verbundenen Baugruppen-Modulteil versehen, welches für den Fall, dass die Baugruppen 2, 3 auf die Tragschiene 1 montiert sind, in ein Verbindungs-Modulteil 4, 5, 6 eingreift und mit diesem elektrisch und mechanisch zusammenwirkt. Die Verbindungs-Modulteile 4, 5, 6 sind auf der Tragschiene 1 verschiebbar ausgestaltet, was bedeutet, dass benachbarte Verbindungs-Modulteile 4, 5, 6 in einem beliebigen Abstand auf der Tragschiene 1 positionierbar sind, was in der Figur 1 durch die Symbole "↔" dargestellt ist. Die Verbindungs-Modulteile 4, 5, 6 weisen jeweils einen mit mehreren Kontakten versehenen Schenkel 4a, 5a, 6a auf, wobei im vorliegenden Beispiel die Schenkel 4a, 5a in dazu korrespondierende Schenkel der Baugruppen 2, 3 eingreifen und elektrisch und mechanisch zusammenwirken. Darüber hinaus sind die Verbindungs-Modulteile 4, 5, 6 jeweils mit einem flexiblen mehradrigen Verbindungsmittel 7, 8, 9 in Form einer flexiblen Leiterplatte oder eines flexiblen mehradrigen Kabels 7, 8, 9 versehen, über welches das jeweilige Verbindungs-Modulteil 4, 5, 6 zur Verwirklichung einer so genannten HUB-Struktur mit einer zentralen Einheit verbunden ist.
Die Abstände benachbarter Verbindungs-Modulteile 4, 5, 6 werden in Abhängigkeit der Baugruppenbreiten gewählt und somit können diese Abstände an die Baugruppenbreiten angepasst werden.
Anstatt einer einfachen HUB-Struktur, in der eine Master- oder CPU-Baugruppe auf jede Baugruppe individuell lesend und/oder schreibend zugreift, kann mit den verschiebbaren Verbindungs-Modulteilen 4, 5, 6 auch eine Bus-Verbindungsstruktur mit einem gemeinsamen Übertragungsweg für alle Baugruppen verwirklicht werden, wobei ein Datentransfer in paralleler oder serieller Form erfolgt und zu einem Zeitpunkt nur eine Nachricht über diesen Übertragungsweg transportiert werden kann. Dazu sind das Verbindungs-Modulteil 4 mit dem flexiblen Kabel 7 mit einer zentralen Einheit, z. B. mit einer CPU-Baugruppe des Automatisierungsgerätes, und die benachbarten Verbindungs-Modulteile 5, 6 mit den flexiblen Kabeln 8, 9 verbunden. Auch hier ist es möglich, die Abstände an die Baugruppenbreiten anzupassen.

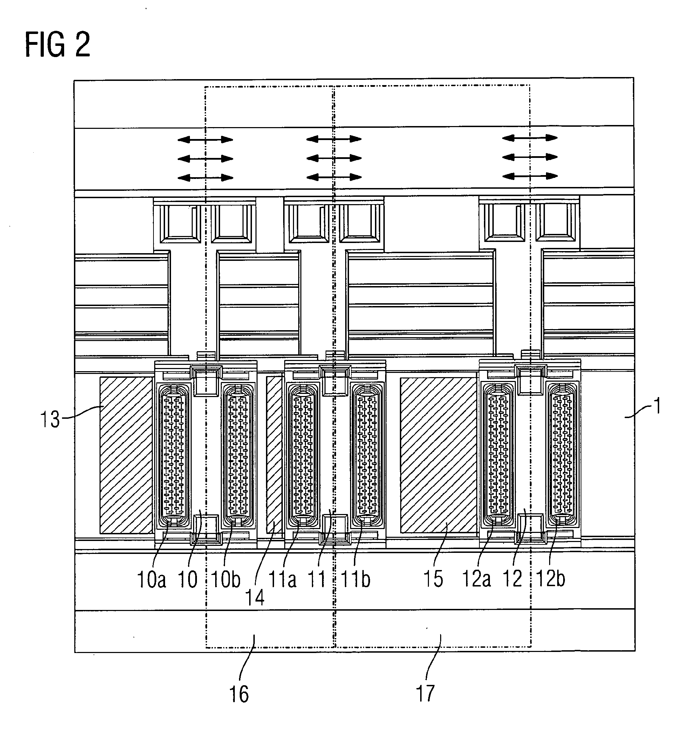

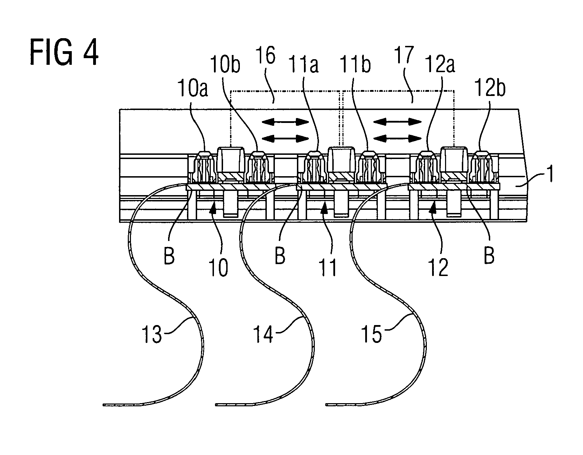

Figur 2 und Figur 4 zeigen eine Ausführungsform mit im Wesentlichen U-förmigen, jeweils mit zwei Schenkeln 10a, 10b, 11a, 11b, 12a, 12b und einer Basis B versehenen Verbindungs-Modulteilen 10, 11, 12. Hier nicht dargestellte, mit einer Leiterplatte elektrisch verbundene Baugruppen-Modulteile von Baugruppen 16, 17 sind ebenfalls im Wesentlichen U-förmig mit zwei Schenkeln und einer Basis ausgebildet, wobei die Verbindungs-Modulteile 10, 11, 12 jeweils den Abstand zwischen zwei benachbarten Schenkeln zweier benachbarter Baugruppen bei zusammengebautem Automatisierungsgerät überbrücken. Die Verbindungs-Modulteile 10, 11, 12 wirken mit den Baugruppen-Modulteilen elektrisch und mechanisch zusammen, wobei ferner die Verbindungs-Modulteile 10, 11, 12 jeweils über ein flexibles mehradriges Kabel 13, 14, 15 mit einer zentralen Baugruppe verbunden sind. Mit einer derartigen Verbindungsstruktur wird eine redundante HUB-Struktur ermöglicht. Für den Fall, dass beispielsweise das flexible Kabel 13 mit einer ersten zentralen Einheit und das Kabel 14 mit einer zweiten zentralen Einheit verbunden sind, ist die Baugruppe 16 sowohl an der ersten als auch an der zweiten zentralen Einheit angeschlossen. Entsprechend ist für den Fall, dass das Kabel 15 an eine dritte zentrale Einheit angeschlossen ist, die Baugruppe 17 sowohl mit der zweiten als auch mit der dritten zentralen Einheit verbunden.

Mit der in Figur 2 gezeigten Ausführungsform lässt sich auch eine so genannte Daisy-Chain-Verbindungsstruktur verwirklichen. Die flexiblen Kabel werden dazu nicht benötigt und sind nicht an zentralen Einheiten angeschlossen. Die Baugruppe 16 ist über das Verbindungs-Modulteil 11 mit der benachbarten Baugruppe 17 verbunden; entsprechend ist das Verbindungs-Modulteil 10 zum Verbinden einer weiteren zur Baugruppe 16 benachbarten und das Verbindungs-Modulteil 12 zum Verbinden einer zur Baugruppe 17 benachbarten Baugruppe vorgesehen. Dabei überbrückt das jeweilige Verbindungs-Modulteil 10, 11, 12 den Abstand benachbarter Schenkel von benachbarten Baugruppen.

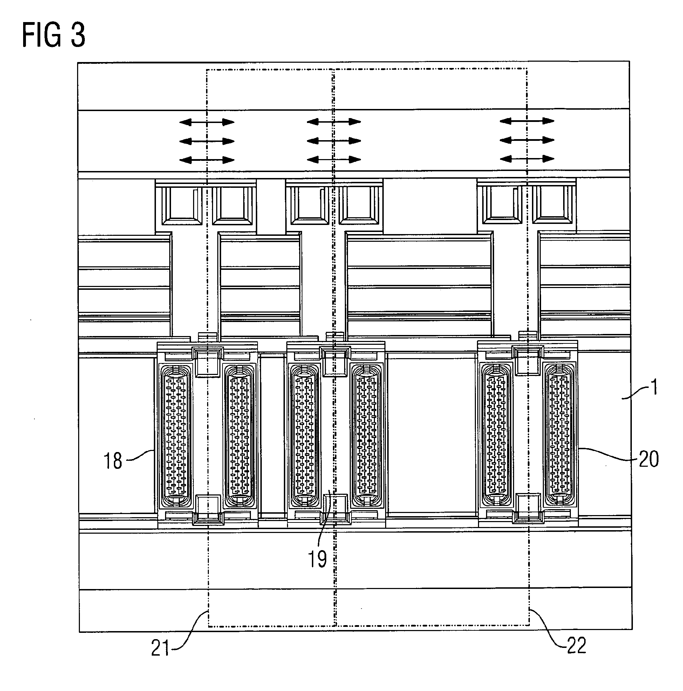

In Figur 3 ist eine Daisy-Chain-Verbindungsstruktur dargestellt, welche mit Verbindungs-Modulteilen 18, 19, 20 versehen ist, die keine flexiblen Kabel aufweisen, wobei die Verbindungs-Modulteile 18, 19, 20 ebenfalls in einem beliebigen Abstand auf der Tragschiene 1 positionierbar sind. Sowohl die Baugruppen-Modulteile von Baugruppen 21, 22 als auch die Verbindungs-Modulteile 18, 19, 20 sind im Wesentlichen U-förmig mit zwei Schenkeln und einer Basis ausgebildet, wobei die Basis der Verbindungs-Modulteile 18, 19, 20 jeweils den Abstand zwischen zwei benachbarten Schenkeln zweier benachbarter Baugruppen 21, 22 überbrückt.

## Patentansprüche

1. Automatisierungsgerät, welches mehrere auf einer Tragschiene (1) angeordnete Baugruppen (2, 3; 16, 17) aufweist, wobei an der Rückwand jeder Baugruppe (2, 3; 16, 17) ein mehrere Kontakte aufweisendes Baugruppen-Modulteil vorgesehen ist, das mit einem ebenfalls mehrere Kontakte aufweisenden Verbindungs-Modulteil (4-6; 10-12) elektrisch und mechanisch zusammenwirkt, **dadurch gekennzeichnet,**
- **dass** die Verbindungs-Modulteile (4-6; 10-12) in einem beliebigen Abstand zueinander auf der Tragschiene (1) positionierbar sind,
- **dass** die Verbindungs-Modulteile (4-6) jeweils einen Schenkel (4a, 5a, 6a) aufweisen, welcher bei zusammengebautem Automatisierungsgerät mit einem Schenkel des Baugruppen-Modulteils einer Baugruppe (2, 3) und über ein flexibles mehradriges Verbindungsmittel (7, 8, 9) mit einer zentralen Baugruppe verbunden ist, und/oder
- **dass** die Verbindungs-Modulteile (10-12) im Wesentlichen U-förmig mit zwei Schenkeln (10a, 10b, 11a, 11b, 12a, 12b) und einer Basis (B) ausgebildet sind, wobei die Baugruppen-Modulteile ebenfalls im Wesentlichen U-förmig mit zwei Schenkeln und einer Basis ausgebildet sind, und die Verbindungs-Modulteile (10-12) jeweils den Abstand zwischen zwei benachbarten Schenkeln zweier benachbarter Baugruppen (16, 17) bei zusammengebautem Automatisierungsgerät überbrücken und die Verbindungs-Modulteile (10-12) über ein flexibles mehradriges Verbindungsmittel (13, 14, 15) jeweils mit einer zentralen Baugruppe verbunden sind und/oder
- **dass** die Verbindungs-Modulteile (4-6) jeweils einen Schenkel (4a, 5a, 6a) aufweisen, welcher bei zusammengebautem Automatisierungsgerät mit einem Schenkel des Baugruppen-Modulteils einer Baugruppe (2, 3) verbunden ist, und eines der Verbindungs-Modulteile (4-6; 10-12) über ein flexibles mehradriges Verbindungsmittel (7, 8, 9) mit einer zentralen Baugruppe (2, 3) und benachbarte Verbindungs-Busmodulteile (4-6) über jeweils ein flexibles mehradriges Verbindungsmittel (7, 8, 9) verbunden sind.

2. Automatisierungsgerät nach Anspruch 1, **dadurch gekennzeichnet,**
- **dass** weitere Verbindungs-Modulteile (18, 19, 20) vorgesehen sind, welche in einem beliebigen Abstand auf der Tragschiene (1) positionierbar sind und welche jeweils im Wesentlichen U-förmig mit zwei Schenkeln und einer Basis (B) ausgebildet sind, und
- **dass** die Baugruppen-Modulteile der Baugruppen (21, 22) ebenfalls im Wesentlichen U-förmig mit zwei Schenkeln und einer Basis ausgebildet sind und die Verbindungs-Modulteile (18, 19, 20) jeweils den Abstand zwischen zwei benachbarten Schenkeln zweier benachbarter Baugruppen (21, 22) bei zusammengebautem Automatisierungsgerät überbrücken.
